# EUROPEAN PATENT APPLICATION

(11) **EP 1 783 669 A2**
(43) Date of publication of application: **09.05.2007**
(21) Application number: 06250279.4
(22) Date of filing: 19.01.2006
(51) Int. Cl.: G06K 19/077

(54) **RFID tag and RFID tag manufacturing method**

(30) Priority: 28.10.2005 JP 2005314831
(71) Applicant: FUJITSU LIMITED, Kawasaki-shi, Kanagawa 211-8588 (JP)
(72) Inventor: Baba, Shunji, c/o Fujitsu Limited, Kawasaki-shi Kanagawa 211-8588 (JP)
(74) Representative: Cooper-Rolfe, Elizabeth Louise

(57) **Abstract**

The present invention provides an RFID (Radio_Frequency_IDentification) tag (100) which exchanges information with external equipment on a non-contact basis and which can both reduce the bending stress and improve reliability under temperature changes. The RFID has a base (113); an antenna pattern (112) which, being installed on the base, forms a communications antenna; a circuit chip (111) which, being electrically connected to the antenna pattern and fixed to the base, conducts wireless communications via the antenna; and a first reinforcement body (116) which covers the circuit chip, being fixed to the base at a location away from the circuit chip without being fixed to the circuit chip.

## Description

The present invention relates to an RFID (Radio_Frequency_IDentification) tag which exchanges information with external equipment on a non-contact basis as well as to its manufacturing method. Incidentally, the RFID tag referred to herein is also known as an "RFID tag inlay" among those skilled in the art, meaning a component laid into the RFID tag. Also, the RFID tag is sometimes called a "wireless IC tag." Besides, the RFID tags include a noncontact IC card.

Recently, various types of RFID tag have been proposed to exchange information with external equipment typified by reader-writers on a non-contact basis by radio. A configuration in which an antenna pattern for wireless communications and an IC chip are mounted on a base sheet made of plastics or paper has been proposed as a type of RFID tag. One possible application for RFID tags of this type is to affix them to goods and identify the goods by exchanging information about the goods with external equipment.

The RFID tag has a wide range of possible applications including the one described above. For example, when affixing the RFID tag to easily deformable goods such as clothing, bending stress is exerted on the IC chip, which is hard to bend whereas the base sheet is flexible. Breakage of the IC chip, separation of the IC chip, and the like which can result from the bending stress poses a major problem and various attempts are made to reduce the bending stress acting on the IC chip.

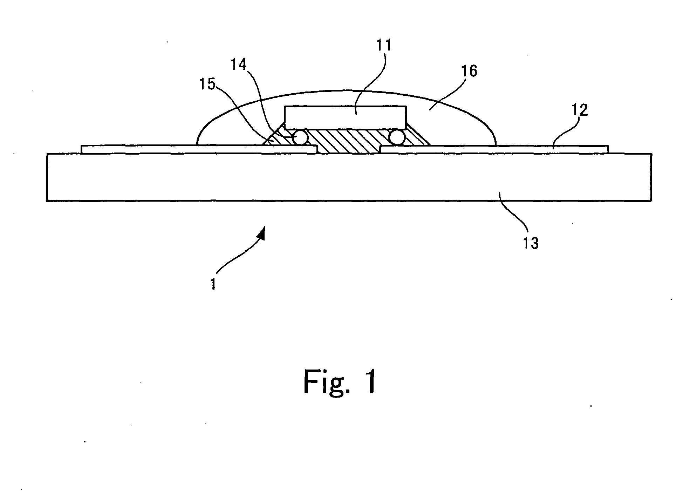

Fig. 1 is a side view of a conventional RFID tag. However, the side view here shows internal structure seen through a flank of the RFID tag. Hereinafter, all side views are of the same nature.

The RFID tag 1 shown in Fig. 1 consists of an antenna 12 mounted on a sheet-type base 13 made of PET film, polyimide film, or the like, an IC chip 11 connected to the antenna 12 via bumps (metal protrusions) 14, an adhesive which bonds the IC chip 11 to the base 13, and a reinforcement body 16 which buries the entire IC chip 11 and part of the antenna 12.

The reinforcement body 16 spreads out bending stress over where the reinforcement body 16 exists, and thereby helps reduce the bending stress acting on the IC chip 11.

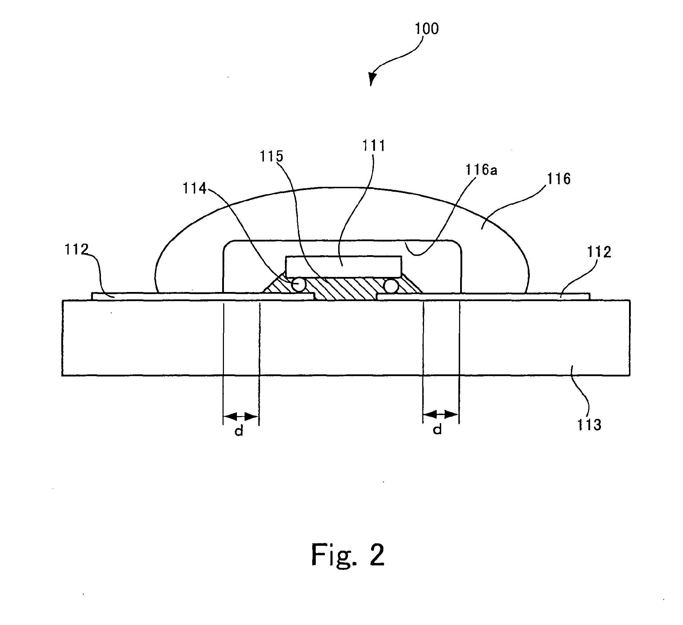

To further reduce bending stress, it has also been proposed to install a reinforcement plate stronger than the reinforcement body 16 on or in the reinforcement body 16 or on the opposite side of the base 13 from the reinforcement body 16 (see, for example, Japanese Patent Laid-Open Nos. 2001-319211 (p.6 and Fig. 1), 2003-288576 (p.6 and Fig. 2), 2005-4429 (p.10 and Fig. 1), and 2005-4430 (p.10 and Fig. 1)).

If the IC chip is protected firmly with a reinforcement body or reinforcement plate as is the case with the conventional techniques, although bending stress is reduced, temperature changes in the operating environment of the RFID tag can cause stress on the IC chip because of difference in thermal expansion (or contraction) between the IC chip and the hard reinforcement body or reinforcement plate. This can result in breakage or separation of the IC chip, presenting a problem of low reliability under temperature changes.

The present invention has been made in view of the above circumstances. Embodiments of the present invention seek to provide an RFID tag which can both reduce the bending stress and improve reliability under temperature changes.

According to an embodiment of a first aspect of the present invention there is provided an RFID tag having:
a base;
an antenna pattern which, being installed on the base, forms a communications antenna;
a circuit chip which, being electrically connected to the antenna pattern and fixed to the base, conducts wireless communications via the antenna; and
a first reinforcement body which covers the circuit chip, being fixed to the base at a location away from the circuit chip without being fixed to the circuit chip.

Since the circuit chip and first reinforcement body are not fixed to each other and fixed at locations apart from each other even, in the case of thermal expansion (or contraction) resulting from temperature changes, any difference in thermal expansion between the circuit chip and first reinforcement body is absorbed by that part of the base which is located between the circuit chip and first reinforcement body, avoiding breakage of the circuit chip. Also, the bending stress acting on the circuit chip is reduced by the first reinforcement body. Thus, the RFID tag according to the present invention can both reduce the bending stress and improve reliability under temperature changes.

Preferably, the RFID tag embodying the present invention has a second reinforcement body located across the base from the first reinforcement body without being fixed to the base right behind the circuit chip.

The second reinforcement bodymakes it possible to further reduce the bending stress acting on the circuit chip while maintaining the capability of the base to absorb the difference in thermal expansion.

Preferably, in the RFID tag embodying the present invention, the first reinforcement body is fixed to the base, but is not fixed to the base right behind the circuit chip where the first reinforcement body covers the base.

The first reinforcement body covering the base also serves as the second reinforcement body in a way. Also, it improves the durability of the RFID tag by giving it watertightness.

Preferably, the RFID tag embodying the present invention has an auxiliary body which, being more flexible than the first reinforcement body, fills at least a boundary between the first reinforcement body and the base.

The auxiliary body allows the RFID tag to spread out the bending stress acting on the boundary between the first reinforcement body and the base, thereby avoiding breaks in the antenna pattern.

Preferably, the RFID tag embodying the present invention has an auxiliary body which, being more flexible than the first reinforcement body, fills a boundary between the first reinforcement body and the base while covering the base.

The auxiliary body which covers the base not only allows the RFID tag to avoid breaks in the antenna pattern as above, but also improves the durability of the RFID tag by giving it watertightness.

According to an embodiment of a second aspect of the present invention there is provided an RFID tag manufacturing method having:
a first adhesive-application step of applying an adhesive to a semi-finished product at a location away from a circuit chip, where the semi-finished product has a base, an antenna pattern which, being installed on the base, forms a communications antenna, and the circuit chip which, being electrically connected to the antenna pattern and fixed to the base, conducts wireless communications via the antenna; and
a first fixing step of fixing a first reinforcement body which covers the circuit chip to the semi-finished product using the adhesive applied in the first adhesive-application step.

The RFID tag manufacturing method embodying the present invention advantageously makes it possible to manufacture the RFID tag according to the present invention easily.

Preferably, the RFID tag manufacturing method according to the present invention has:
a second adhesive-application step of applying an adhesive to the semi-finished product on the side, which is opposite the side where the first reinforcement body is fixed, by avoiding a location right behind the circuit chip; and
a second fixing step of fixing a second reinforcement body located across the base from the first reinforcement body using the adhesive applied in the second adhesive-application step.

This preferred RFID tag manufacturing method makes it easy to manufacture a preferable RFID tag equipped with a reinforcement body even on the reverse side of the base.

As described above, the present invention seeks to provide an RFID tag which can both reduce the bending stress and improve reliability under temperature changes.

For a better understanding of the present invention, and to show how the same may be carried into effect, reference will now be made, by way of example to the accompanying drawings in which:
Fig. 1 is a side view of a conventional RFID tag;
Fig. 2 is a side view of an RFID tag according to a first embodiment of the present invention;
Fig. 3 is a side view of an RFID tag according to a second embodiment of the present invention;
Fig. 4 is a side view of an RFID tag according to a third embodiment of the present invention;
Fig. 5 is a side view of an RFID tag according to a fourth embodiment of the present invention;
Fig. 6 is a side view of an RFID tag according to a fifth embodiment of the present invention;
Fig. 7 is a side view of an RFID tag according to a sixth embodiment of the present invention;
Fig. 8 is a side view of an RFID tag according to a seventh embodiment of the present invention;
Fig. 9 is a process chart showing a process of fixing a reinforcement body to an inlay;
Fig. 10 is a process chart showing a process of forming an auxiliary body around a reinforcement body;
Fig. 11 is a process chart showing a process of forming a reinforcement body which entirely covers an inlay; and
Fig. 12 is a process chart showing a process of forming an auxiliary body which entirely covers an inlay.

Embodiments of the present invention will be described below with reference to the drawings.

Fig. 2 is a side view of an RFID tag according to a first embodiment of the present invention.

The RFID tag 100 shown in Fig. 2 consists of a sheet-type base 113 made of PET film, an antenna 112 made of thin copper film and mounted on the base 113, an IC chip 111 mainly made of Si and connected to the antenna 112 via bumps (metal protrusions) 114, an adhesive 115 made of thermosetting epoxy resin and bonding the IC chip 111 to the base 113, and a reinforcement body 116 which, being made of polyphenylene sulfide and fixed to the base 113, covers the entire IC chip 111 and part of the antenna 112.

Besides the polyphenylene sulfide, possible materials for the reinforcement body 116 include other plastic resins, which are as hard as PPS, such as ABS (acrylonitrile-butadiene-styrene copolymer) and polycarbonate, ceramic, and metal. In addition to the PET film described above, a wide range of materials are available for the base 113 including other polyester resins such as PET-G (noncrystal polyester resins), polyvinyl chloride, ABS (acrylonitrile-butadiene-styrene copolymer), cellulosic resins, vinyl acetate resins, polystyrene resins, and polyolefin resins. Possible materials for the antenna 112 include, in addition to the thin copper film described above, thin film of other metals such as aluminum, iron, and nickel; and paste material of epoxy or other resins mixed with metal filler (generally, Ag) to give electrical conductivity.

The reinforcement body 116 is an example of the first reinforcement body according to the present invention. It is shaped like a cap with a wide inner wall 116a formed in such a way as to provide a clearance between itself and the IC chip 111 . The base 113 is free of hard structure in a portion d between fixing positions of the reinforcement body 116 and IC chip 111. Although the base 113 is shown as being thicker in Fig. 2 than it really is for purposes of illustration, actually the base 113 is thin, and thus it deforms and extends easily in the portion d. Consequently, even if temperature changes in the operating environment of the RFID tag 100 cause differences in expansion or contraction between the reinforcement body 116 made of polyphenylene sulfide and IC chip 111 mainly made of Si, the differences are absorbed by the portion d of the base 113, preventing breakage or separation of the IC chip 111. This increases reliability of the RFID tag 100 under temperature changes.

Also, since the reinforcement body 116 is fixed to the base 113 while covering the IC chip 111, any bending stress caused by bending of the base 113 is received and spread by the reinforcement body 116, which thus reduces the bending stress acting on the IC chip 111.

This concludes description of the first embodiment. Various other embodiments different from the first embodiment will be described below, wherein the same components as those of the first embodiment will be denoted by the same reference numerals as corresponding components of the first embodiment and description thereof will be omitted to avoid redundancy. The following description of the embodiments will focus on differences from the first embodiment.

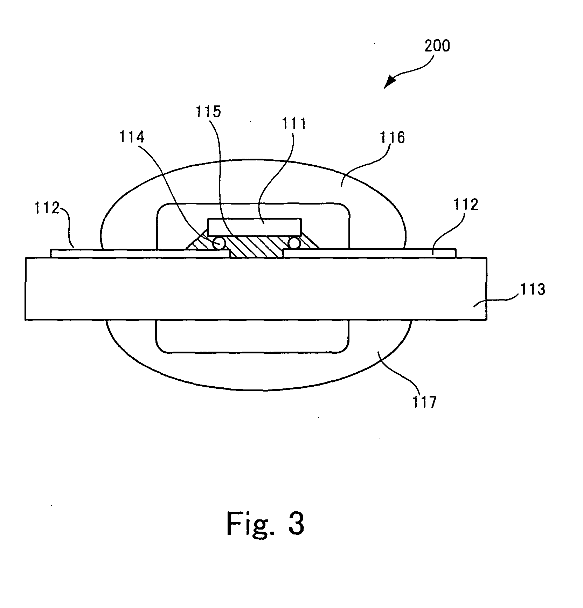

Fig. 3 is a side view of an RFID tag according to a second embodiment of the present invention.

In addition to the reinforcement body 116 which covers the IC chip 111, the RFID tag 200 according to the second embodiment is equipped with another reinforcement body 117 located on the opposite side of the base 113 from the reinforcement body 116. The reinforcement body 117 is an example of the second reinforcement body according to the present invention. It has the same shape as the reinforcement body 116 which covers the IC chip 111. Consequently, absorption of the differences in expansion or contraction by the portion d shown in Fig. 2 is not obstructed. Thus, the RFID tag 200 according to the second embodiment also has high reliability under temperature changes. Also, the existence of the second reinforcement body 117 further reduces the bending stress caused by bending of the base 113 because the bending stress is spread out by the two reinforcement bodies 116 and 117.

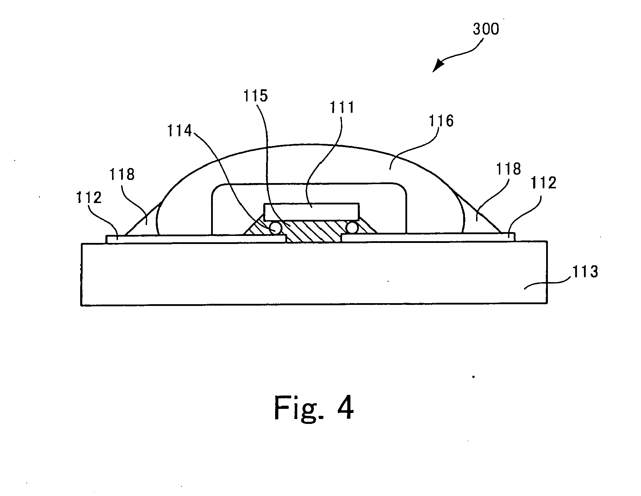

Fig. 4 is a side view of an RFID tag according to a third embodiment of the present invention.

The RFID tag 300 according to the third embodiment has an auxiliary body 118 which is more flexible (i.e., lower in bending strength or Young's modulus) than the reinforcement body 116 along the boundary between the reinforcement body 116 and base 113. Incidentally, although the auxiliary body 118 is shown as riding the antenna 112 in Fig. 3 for the convenience of illustration, the antenna 112 is provided only in part of the periphery of the reinforcement body 116 while the auxiliary body 118 is provided in a wide area along the periphery of the reinforcement body 116.

The auxiliary body 118 is an example of the auxiliary body according to the present invention. Possible materials for the auxiliary body 118 include rubber materials such as urethane rubber and silicone rubber as well as epoxy adhesives, thermosetting silicone resins, and ultraviolet-curing acrylic resins.

With the RFID tag 300 according to the third embodiment, the bending stress caused by bending of the base 113 is spread out by the auxiliary body 118, reducing stress concentration on the boundary between the reinforcement body 116 and base 113, and thereby preventing breakage of the antenna 112.

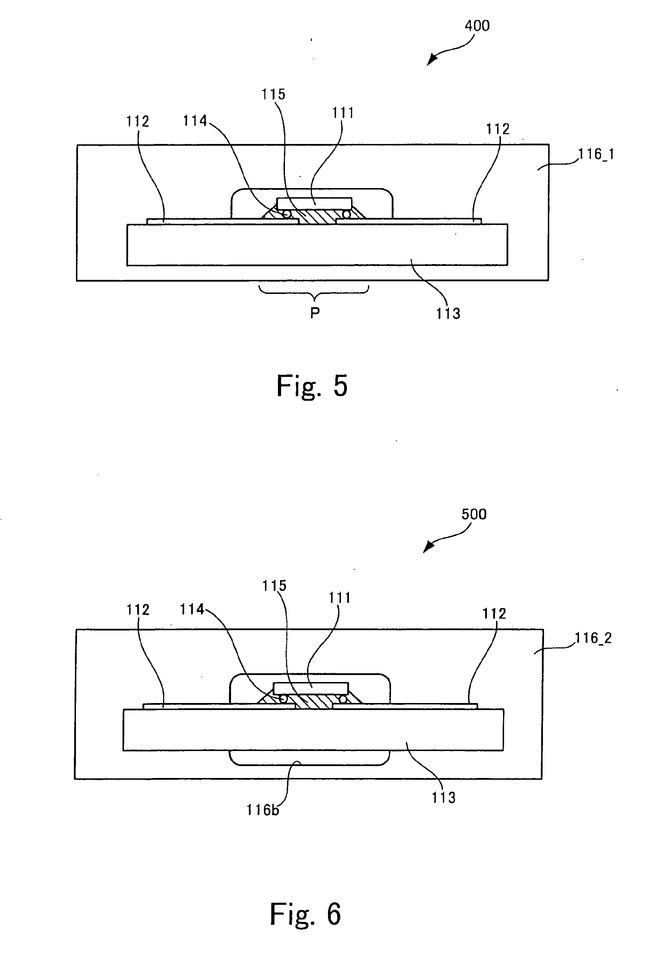

Fig. 5 is a side view of an RFID tag according to a fourth embodiment of the present invention.

Instead of the reinforcement body 116 shown in Fig. 2, the RFID tag 400 according to the fourth embodiment is equipped with a reinforcement body 116_1 covering the entire base 113. Although the reinforcement body 116_1 is fixed to the base 113, that part P of the reinforcement body 116_1 which is right behind the IC chip 111 is not fixed to the base 113. Consequently, according to the fourth embodiment again, the differences in expansion or contraction is absorbed by the portion d shown in Fig. 2, resulting in high reliability under temperature changes. Also, the structure in which the reinforcement body 116_1 covers the entire base 113 further increases strength against bending stress. Furthermore, the reinforcement body 116_1 according to the fourth embodiment has a watertight structure which gives the RFID tag 400 high durability and makes it serviceable in a wide range of use environments.

Fig. 6 is a side view of an RFID tag according to a fifth embodiment of the present invention.

The RFID tag 500 according to the fifth embodiment is equipped with a reinforcement body 116_2 slightly different from the reinforcement body 116_1 according to the fourth embodiment. The reinforcement body 116_2 has an inner wall b at a location corresponding to the part P right behind the IC chip 111 in Fig. 5. Thus, the reinforcement body 116_2 is not only unfixed to the part P, but also free from contact with it. Consequently, any pinching force acting in the up-and-down direction in the drawing on the RFID tag 500 at a location around the IC chip 111 is hard to be transmitted to the IC chip 111. This increases the safety of the IC chip 111 and reliability of the RFID tag 500.

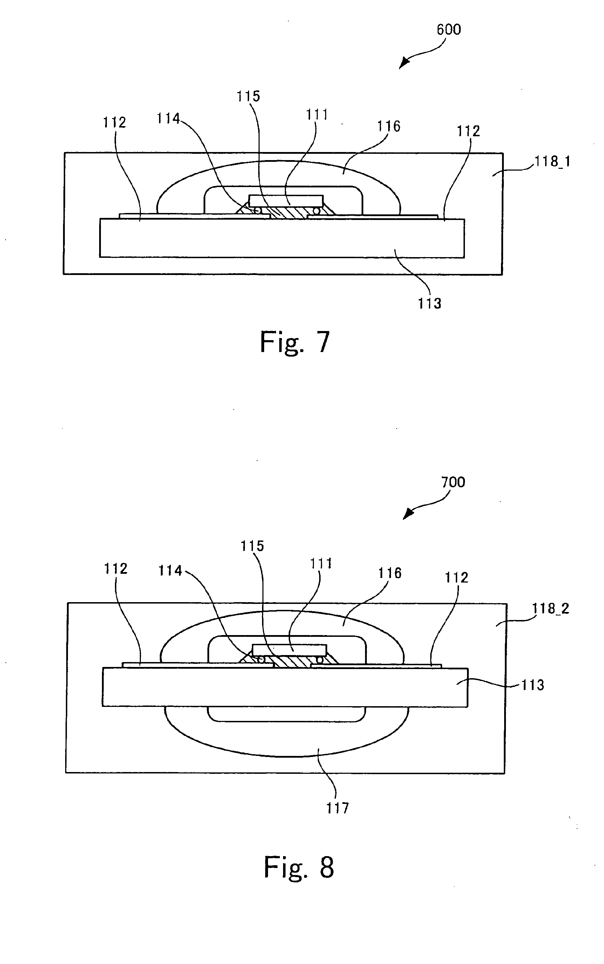

Fig. 7 is a side view of an RFID tag according to a sixth embodiment of the present invention.

Instead of the auxiliary body 118 according to the third embodiment, the RFID tag 600 according to the sixth embodiment is equipped with an auxiliary body 118_1 which entirely covers the reinforcement body 116 and base 113 and has a watertight structure.

Since the auxiliary body 118_1 is flexible, the RFID tag 600 is bendable as a whole. The stress produced when the RFID tag 600 bends is spread out as in the case of the third embodiment and the like. Consequently, the RFID tag 600 according to the sixth embodiment is effective for applications which assume that the RFID tag will be bent, including applications where the RFID tag 600 is affixed to bendable goods such as clothing.

Fig. 8 is a side view of an RFID tag according to a seventh embodiment of the present invention.

The RFID tag 700 according to the seventh embodiment of the present invention has reinforcement bodies 116 and 117 on both sides of the base as in the case of the second embodiment shown in Fig. 3 as well as an auxiliary body 118_2 which entirely covers the reinforcement bodies 116 and 117 and base 113. Again, the auxiliary body 118_2 has a watertight structure.

Since the bending stress is spread out by the two reinforcement bodies 116 and 117, the RFID tag 700 is more effective for applications which assume that the RFID tag will be bent.

This concludes the description of structures according to various embodiments. Now description will be given of manufacturing methods for the embodiments described above, but instead of describing a manufacturing method for each embodiment redundantly, description will be given of elemental processes used as appropriate in the manufacture of individual embodiments. The embodiments described above are manufactured using the following processes as appropriate.

A group of the components (from the IC chip 111 to the adhesive 115) shown in Fig. 2 excluding the reinforcement body 116 will be referred to as an "inlay" without any reference character. Regarding manufacturing processes of the inlay, known manufacturing processes can be used as appropriate, and thus description thereof will be omitted.

First, a process of fixing a reinforcement body to an inlay will be described.

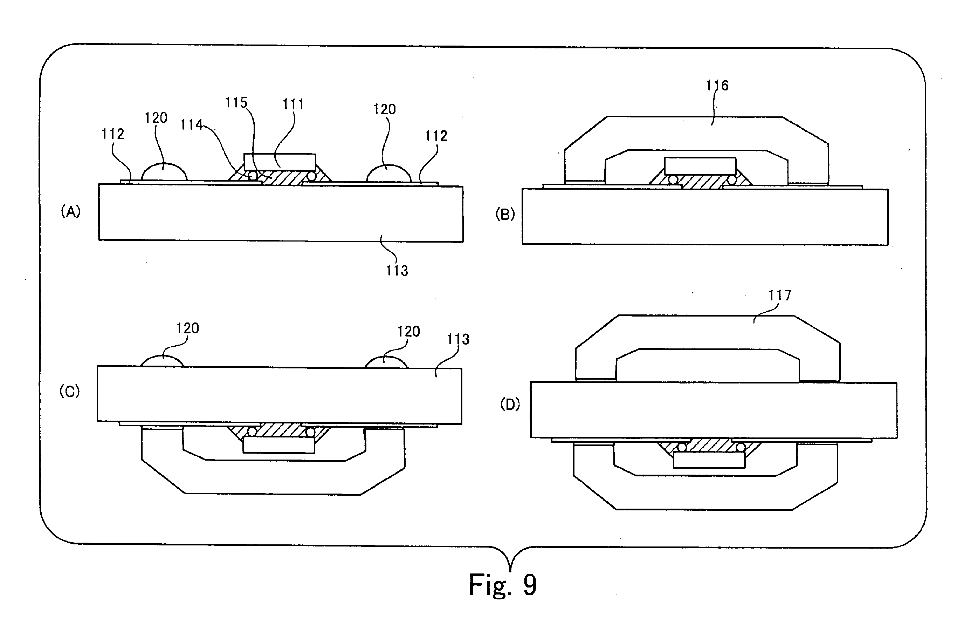

Fig. 9 is a process chart showing a process of fixing a reinforcement body to an inlay.

In this process, a bonding adhesive 120 made of thermosetting epoxy resin is applied to the inlay in such a way as to surround the IC chip 111 as shown in part (A) of Fig. 9, then the reinforcement body 116 is placed on the adhesive 120 in alignment with the IC chip 111 and the like as shown in part (B) of Fig. 9, and the adhesive is cured by heating. The step shown in part (A) is an example of the first adhesive-application step according to the present invention while the step shown in part (B) is an example of the first fixing step according to the present invention.

When the reinforcement bodies 116 and 117 are installed on both sides of the inlay as in the case of the second and seventh embodiments, the adhesive 120 is applied to the surface opposite to the surface to which the reinforcement body 116 is fixed as shown in part (C), the other reinforcement body 117 is placed in alignment on the adhesive 120 as shown in part (D), and the adhesive is cured by heating. The step shown in part (C) is an example of the second adhesive-application step according to the present invention while the step shown in part (D) is an example of the second fixing step according to the present invention.

Through the above process, the reinforcement bodies 116 and 117 are fixed to the inlay.

Next, a process of forming an auxiliary body around a reinforcement body will be described.

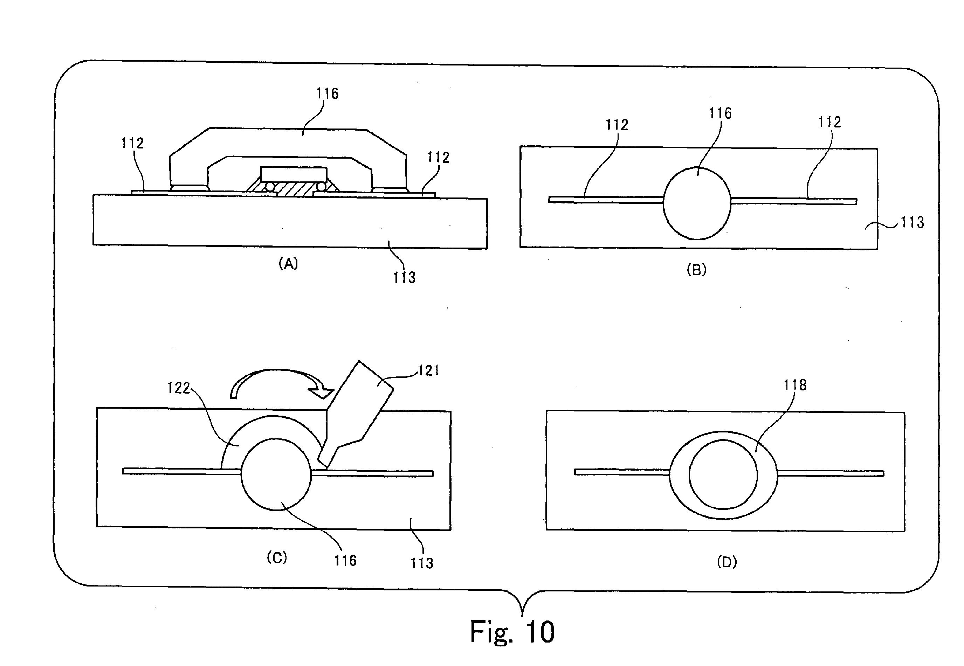

Fig. 10 is a process chart showing a process of forming an auxiliary body around a reinforcement body.

This process uses an assembly consisting of the reinforcement bodies fixed to the inlay in the process shown in Fig. 9. Part (A) of Fig. 10 shows an assembly consisting of the reinforcement body 116 fixed to one side of the inlay as an example while part (B) shows the inlay in the same state as viewed from above the reinforcement body 116. The antenna 112 is installed on the base 113 and the reinforcement body 116 covering part of the base 113 is fixed to the antenna 112. Thus, edges of the reinforcement body 116 cross the antenna 112 at some locations and an auxiliary body is provided to prevent the antenna from being broken at these locations.

A fluid 122 such as thermosetting silicone resin or ultraviolet-curing acrylic resin which is an ingredient of an auxiliary body is applied around the reinforcement body 116 along the boundary between the reinforcement body 116 and base 113 by a dispenser 121 as shown in part (C) of Fig. 10 and the fluid 122 is cured by heating or ultraviolet irradiation, thereby forming the auxiliary body 118 around the reinforcement body 116 as shown in part (D).

The process described above can be used as it is even when providing an auxiliary body on a reinforcement body installed on the opposite side of the inlay from the IC chip 111.

Next, a process of forming a reinforcement body which entirely covers an inlay will be described.

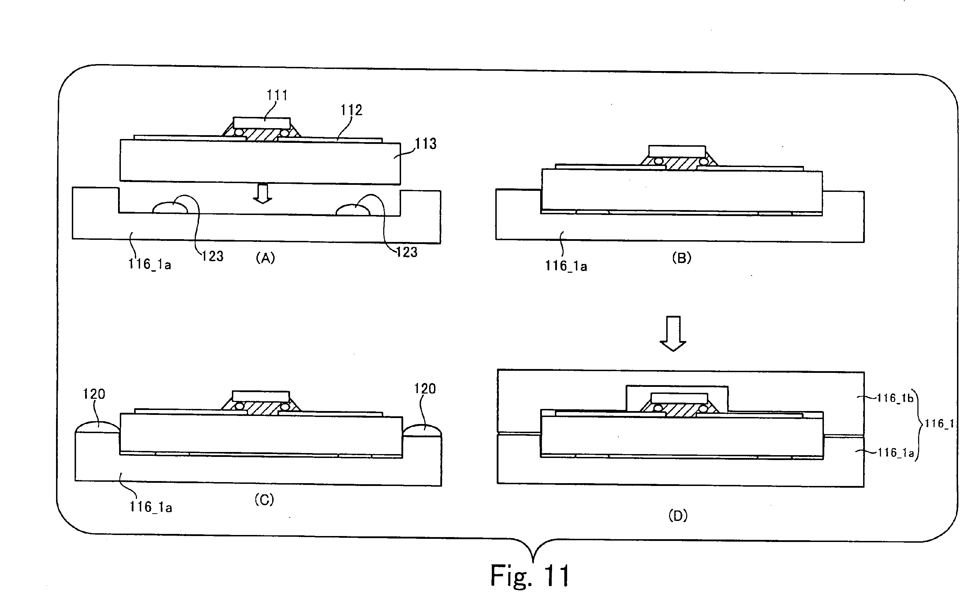

Fig. 11 is a process chart showing a process of forming a reinforcement body which entirely covers an inlay.

It is assumed here that the reinforcement body has a block construction. As shown in part (A) of Fig. 11, a lower cover 116_1a of the reinforcement body has a recess into which the inlay fits snugly. A bonding adhesive 123 made of ultraviolet-curing acrylic resin is applied to the inner part of the recess. In so doing, the adhesive 123 is applied by avoiding the part P right behind the IC chip 111 in Fig. 5.

Next, as shown in part (B) of Fig. 11, the inlay is aligned with and fitted in the recess of the lower cover 116_1a and ultraviolet rays are emitted from the inlay to cure the adhesive 123, thereby fixing the inlay and the lower cover 116_1a together. Incidentally, although an ultraviolet-curing resin is used for the bonding adhesive assuming that the base 113 of the inlay is made of PET or similar material transparent to ultraviolet rays, a thermosetting resin may be used for the bonding adhesive if the base 113 is not transparent to ultraviolet rays.

Next, the adhesive 120 is applied to a peripheral part of the lower cover 116_1a as shown in part (C) of Fig. 11, an upper cover 116_1b is mounted on the lower cover 116_1a in alignment with the latter as shown in part (D), and the adhesive 120 is cured by heating, thereby forming the reinforcement body 116_1.

Incidentally although Fig. 11 illustrates, as an example, how to form the reinforcement body 116_1 according to the fourth embodiment, the process shown in Fig. 11 also applies as it is to the reinforcement body 116_2 according to the fifth embodiment.

Finally, a process of forming an auxiliary body which entirely covers an inlay will be described.

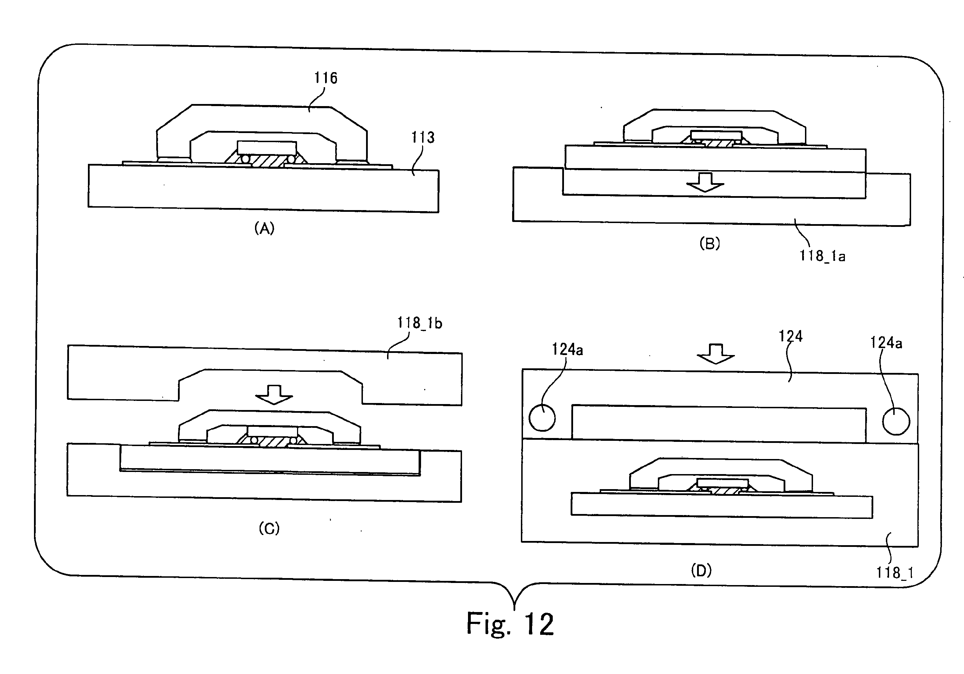

Fig. 12 is a process chart showing a process of forming an auxiliary body which entirely covers an inlay.

Again, this process uses an assembly consisting of the reinforcement bodies fixed to the inlay in the process shown in Fig. 9. Part (A) of Fig. 12 shows an assembly consisting of the reinforcement body 116 fixed to one side of the inlay as an example. It is assumed here that the auxiliary body has a block construction. As shown in part (B) of Fig. 12, a lower cover 118_1a of the auxiliary body in which the auxiliary body is divided has a recess into which the inlay fits snugly. The inlay is aligned with and fitted in the recess.

Next, as shown in part (C) of Fig. 12, an upper cover 118_1b of the auxiliary body in which the auxiliary body is divided is mounted on the lower cover 118_1a in alignment with the latter. The upper cover 118_1b has a recess to accept the reinforcement body 116.

Next, as shown in part (D), areas around the inlay are heated under pressure by a heating fixture 124 with a built-in heater 124a. Consequently, a peripheral part of the lower cover 118_la and peripheral part of the upper cover 118_1b are fused together, thereby forming the auxiliary body 118_1 which covers the inlay.

Incidentally, although Fig. 12 illustrates, as an example, how the auxiliary body 118_1 according to the sixth embodiment is formed, the process shown in Fig. 12 also applies as it is to the auxiliary body 118_2 according to the seventh embodiment.

Each of the embodiments described above are manufactured using an appropriate selection or combination of the processes described above.

Incidentally, although a reinforcement body free from contact with the IC chip has been described as an example of the first reinforcement body according to the present invention, the first reinforcement body according to the present invention may be placed in contact with the IC chip as long as it is not fixed to the IC chip.

## Claims

1. An RFID tag comprising:
a base;
an antenna pattern which, being installed on the base, forms a communications antenna;
a circuit chip which, being electrically connected to the antenna pattern and fixed to the base, conducts wireless communications via the antenna; and
a first reinforcement body which covers the circuit chip, being fixed to the base at a location away from the circuit chip without being fixed to the circuit chip.

2. The RFID tag according to claim 1, further comprising a second reinforcement body located across the base from the first reinforcement body without being fixed to the base right behind the circuit chip.

3. The RFID tag according to claim 1 or 2, wherein the first reinforcement body is fixed to the base, but is not fixed to the base right behind the circuit chip where the first reinforcement body covers the base.

4. The RFID tag according to claim 1, 2 or 3, further comprising an auxiliary body which, being more flexible than the first reinforcement body, fills at least a boundary between the first reinforcement body and the base.

5. The RFID tag according to claim 1, 2 or 3, further comprising an auxiliary body which, being more flexible than the first reinforcement body, fills a boundary between the first reinforcement body and the base while covering the base.

6. An RFID tag manufacturing method comprising:
a first adhesive-application step of applying an adhesive to a semi-finished product at a location away from a circuit chip, where the semi-finished product comprises a base, an antenna pattern which, being installed on the base, forms a communications antenna, and the circuit chip which, being electrically connected to the antenna pattern and fixed to the base, conducts wireless communications via the antenna; and
a first fixing step of fixing a first reinforcement body which covers the circuit chip to the semi-finished product using the adhesive applied in the first adhesive-application step.

7. The RFID tag manufacturing method according to claim 6, further comprising:
a second adhesive-application step of applying an adhesive to the semi-finished product on the side, which is opposite the side where the first reinforcement body is fixed, by avoiding a location right behind the circuit chip; and
a second fixing step of fixing a second reinforcement body located across the base from the first reinforcement body using the adhesive applied in the second adhesive-application step.
